# EUROPÄISCHE PATENTSCHRIFT

(11) **EP 3 635 503 B1**
(45) Veröffentlichungstag und Bekanntmachung des Hinweises auf die Patenterteilung: **08.09.2021**
(21) Anmeldenummer: 18782680.5
(22) Anmeldetag: 27.09.2018
(51) Int. Cl.: G05G 5/04, B60K 37/06, H03K 17/96, H03K 17/965

(54) **BEDIENELEMENT MIT VERBESSERTER HAPTIKEIGENSCHAFT**
OPERATING ELEMENT WITH IMPROVED HAPTIC PROPERTY
ÉLÉMENT DE COMMANDE À PROPRIÉTÉ HAPTIQUE AMÉLIORÉE

(30) Priorität: 02.10.2017 DE 102017122863; 13.08.2018 DE 102018119590
(43) Veröffentlichungstag der Anmeldung: 15.04.2020
(73) Patentinhaber: PREH GmbH, 97616 Bad Neustadt a.d. Saale (DE)
(72) Erfinder: WEGHENKEL, Johannes, 98646 Hildburghausen (DE); SCHUSTEK, Wolfgang, 97618 Wülfershausen (DE); ERHART, Bernd, 97633 Großeibstadt (DE); LANG, Kai, 97654 Bastheim (DE); KLOSSEK, Arthur, 97616 Bad Neustadt (DE)
(74) Vertreter: Lohmanns, Bernard
(86) Internationale Anmeldenummer: PCT/EP2018/076288
(87) Internationale Veröffentlichungsnummer: WO 2019/068555

(56) Entgegenhaltungen:
- WO-A1-01/54109
- WO-A1-2016/079458
- WO-A1-2017/090448
- WO-A1-2018/115524
- DE-A1-102015 008 571
- FR-A1- 2 985 331

## Beschreibung

Die vorliegende Erfindung betrifft ein Bedienelement mit einem gegenüber einem Träger, in Richtung des Trägers beweglich gelagertes Betätigungsteils mit verbesserter Haptikeigenschaft. Insbesondere ist das Bedienelement zur Verwendung in einem Fahrzeug vorgesehen und dazu ausgebildet verschiedene Fahrzeugfunktionen anzusteuern.

Bedienelement zum Ansteuern von Fahrzeugfunktionen sind häufig als Drehsteller, Drücksteller und/oder berührungsempfindliche Betätigungsteile konzipiert. Letztere werden in jüngerer Zeit häufig mit zusätzlichen Stellungssensoren und einem Aktuator versehen, um das Risiko von Fehlbedienungen zu verringern. Die verwendeten Stellungssensoren beruhen oftmals auf dem Prinzip einer Abstandsmessung zwischen einem Betätigungsteil und einem Träger. Dabei ist das Betätigungsteil unter Einwirkung einer Betätigungskraft in Richtung des Trägers bewegbar. Die Bewegung wird durch einen Endanschlag begrenzt, wenn das Betätigungsteil und der Träger auf einander treffen. Dabei wird ein "harter" Endanschlag von einem Nutzer aus haptischer und akustischer Sicht als minderwertig empfunden.

Die WO 2017/090448 A1, die als naheliegendster Stand der Technik betrachtet wird, die WO 01/54109 A1 sowie die WO 2016/079458 A1 offenbaren ein Bedienelement gemäß den Oberbegriffen der Ansprüche 1 und 3. Aufgabe der Erfindung ist es daher, ein Bedienelement bereitzustellen, das verbesserte Haptikeigenschaften aufweist. Diese Aufgabe wird gelöst durch ein Bedienelement mit den Merkmalen des Anspruchs 1, des Anspruchs 3 sowie durch den nebengeordneten Verwendungsanspruch. Vorteilhafte Ausgestaltungen sind jeweils Gegenstand der abhängigen Ansprüche. Es ist darauf hinzuweisen, dass die in den Ansprüchen einzeln aufgeführten Merkmale in beliebiger, technologisch sinnvoller Weise miteinander kombiniert werden können und weitere Ausgestaltungen der Erfindung aufzeigen. Die Beschreibung, insbesondere im Zusammenhang mit den Figuren, charakterisiert und spezifiziert die Erfindung zusätzlich.

Ein erfindungsgemäßes Bedienelement weist einen Träger und ein in Richtung des Trägers unter Einwirkung einer Betätigungskraft beweglich gelagertes Betätigungsteil auf. Das Betätigungsteil weist eine einem Nutzer zugewandte berührungsempfindliche Oberfläche auf, wobei das Betätigungsteil unter Einwirkung einer Betätigungskraft, die senkrecht zur der berührungsempfindlichen Oberfläche in Richtung des Trägers wirkt, aus einer Ruhestellung in eine Betätigungsstellung bewegbar ist. Insbesondere ist das Betätigungsteil schwimmend gelagert, so dass es in alle Raumrichtungen bewegbar ist, wobei die Bewegungen, die es in eine Raumrichtung ausführen kann insbesondere kleiner als 1 mm sind. Ferner weist das Betätigungsteil auf der berührungsempfindlichen Oberfläche wenigstens zwei Betätigungsbereiche auf. Beispielsweise sind den Betätigungsbereichen verschiedene Funktionen zugeordnet, die bei Betätigung ausgeführt werden, wenn eine vorbestimmte Betätigungskraft angewandt wird, beziehungsweise eine Kraftschwelle überschritten wird. Die Kraftschwelle liegt bevorzugt zwischen 3-5N. Mit Betätigungskraft ist die Kraftkomponente gemeint, die senkrecht zu der berührungsempfindlichen Oberfläche wirkt. Die Betätigungsstellung meint dann die Stellung, die das Betätigungsteil gerade dann hat, wenn eine Funktion ausgeführt wird.

Als Berührung wird ein kraftloser Kontakt mit der berührempfindlichen Oberfläche bezeichnet. Bei einer Berührung wird keine Betätigungskraft ausgeübt. Bei einer Betätigung wird hingegen eine Betätigungskraft ausgeübt.

Erfindungsgemäß sind zwischen einer dem Nutzer abgewandten Seite des Betätigungsteils und dem Träger berührungslose Sensoren angeordnet, die dazu ausgebildet sind die Einwirkung einer Betätigungskraft zu ermitteln.

Ein erfindungsgemäßes Bedienelement weist ferner einen trägerseitigen Endanschlag auf. Zwischen der dem Nutzer abgewandten Seite des Betätigungsteils und dem Endanschlag ist zudem ein Anschlagsbegrenzer angeordnet. Der Anschlagsbegrenzer weist eine progressive Kennlinie auf und wird unter Einwirkung der Betätigungskraft komprimiert, bevor der Endanschlag erreicht wird. Progressive Kennlinie bedeutet, dass die Kennlinie im Kraft-Weg Diagramm zumindest im Bereich des Endanschlags eine positive Krümmung aufweist. Es muss kein spezieller Endanschlag vorgesehen sein. Ein Endanschlag ergibt sich spätestens dann, wenn sich bedienteilseitige und trägerseitige Bereiche berühren, beispielsweise im Randbereich. Da das Bedienteil und der Träger häufig aus einem Kunststoff hergestellt ist, wird das Zusammentreffen beider Teile als hart und unangenehm empfunden. Durch die erfindungsgemäß vorgesehenen Anschlagsbegrenzer entfällt ein solcher harter Endanschlag.

Beispielsweise werden Gummifedern, -klötze oder -ringe als Anschlagsbegrenzer verwendet.

Bevorzugt ist das Betätigungsteil in eine Anschlagsbegrenzungsstellung bewegbar. Die Anschlagsbegrenzungsstellung ist die Stellung, in der das Betätigungsteil in Berührkontakt mit dem Anschlagsbegrenzer tritt. In einer Ausgestaltung liegt die Anschlagsbegrenzungsstellung zwischen der Ruhestellung und der Betätigungsstellung. Anders ausgedrückt, das Betätigungsteil weist einen lichten Abstand zwischen der dem Nutzer abgewandten Seite des Betätigungsteils und dem Anschlagsbegrenzer auf.

In einer Ausgestaltung entspricht die Anschlagsbegrenzungsstellung der Ruhestellung.

Berührt ein Nutzer eine der Betätigungsbereiche, so wird durch die berührungsempfindliche Oberfläche ermittelt, welcher Betätigungsbereich berührt wurde. Beispielsweise weist das Betätigungsteil ein die berührungsempfindliche Oberfläche definierenden Touchscreen oder Touchpad auf. Bei einem Touchscreen handelt es sich bekanntermaßen um eine Kombination einer berührempfindlichen Oberfläche mit einer elektronischen Pixelmatrixanzeige, wobei die berührempfindliche Oberfläche mit der Anzeigefläche zur Deckung gebracht angeordnet sind, wohingegen bei einem Touchpad eine elektronische Pixelmatrixanzeige entfällt. Beiden gemeinsam ist eine Sensormatrix zur Berührdetektion, die der Oberfläche zugeordnet ist. Beispielsweise handelt es sich bei der Sensormatrix um ein Elektrodenarray, das ein die Berührfläche bedeckendes Array von durch die Berührung beeinflussten Messkapazitäten erzeugt.

Die weiteren berührungslos arbeitenden Sensoren dienen dazu die Einwirkung einer Betätigungskraft zu erkennen, damit eine dem berührten Betätigungsbereich zugeordnete Funktion ausgelöst wird. Beispielsweise handelt es sich bei den berührungslos arbeitenden Sensoren um resistive, induktive, optische oder kapazitive Sensoren.

Über Sensoren können zudem dazu ausgebildet sein über Triangulation den durch die berührungsempfindliche Oberfläche ermittelten Betätigungsbereich zu verifizieren. Insbesondere sind dazu mindestens drei Sensoren vorgesehen.

Im Wesentlichen erkennen die Sensoren eine aufgrund einer Betätigungskraft bewirkte Abstandsänderung eines lichten Abstands zwischen zumindest einem Bereich des Betätigungsteils und einem Bereich auf der dem Nutzer zugewandten Seite des Trägers. Dabei verändert sich bevorzugt der lichte Abstand nur geringfügig, das heißt, um weniger als einen Millimeter, <1 mm, besonders bevorzugt um weniger als einen halben Millimeter, <0,5 mm. Große Verstellwege des Betätigungsteils aus der Ruhestellung in die Betätigungsstellung werden von dem Nutzer als negativ und minderwertig wahrgenommen werden. Zudem könnte sich durch größere Verstellwege das Spiel zwischen dem Betätigungsteil und dem Träger erhöhen, Spaltmaße könnten sich vergrößern und das Bedienelement insgesamt anfälliger für das Eindringen von Fremdpartikeln werden.

In einer Ausgestaltung der Erfindung werden als Sensoren kapazitive Kraftsensoren verwendet. Unter Einwirkung der Betätigungskraft senkrecht zu der berührungsempfindlichen Oberfläche ändert sich der lichte Abstand zwischen einer ersten Elektrode und einer zweiten Elektrode. Die erste oder die zweite Elektrode ist dabei auf Erdpotential gelegt, die andere Elektrode wird aktiv angesteuert, wodurch die Elektroden einen Messkondensator ausbilden. Insbesondere ist die erste Elektrode ist auf der dem Nutzer abgewandten Seite des Betätigungsteils angeordnet und die zweite Elektrode ist trägerseitig gegenüber angeordnet. Beispielsweise sind abhängig von der Anordnung der Kraftsensoren und der Anschlagsbegrenzer unterschiedliche Sensorwerte vorgesehen, die zur Auslösung einer dem Betätigungsbereich zugeordneten Funktion führen.

Erfindungsgemäß sind mehrere Anschlagsbegrenzer vorgesehen. Insbesondere sind die Anschlagsbegrenzer in einem Randbereich zwischen dem Betätigungsteil und dem Träger angeordnet. Dadurch wird bewirkt, dass das Betätigungsteil besonders bei Einwirkung der Betätigungskraft im Randbereich nicht abrupt in den Endanschlag übergeht. Beispielsweise weist das Betätigungsteil eine viereckige Fläche auf und zwischen jeder Ecke der viereckigen Fläche und dem Träger ist je ein Anschlagsbegrenzer angeordnet.

Die Anschlagsbegrenzer wirken zudem wie erste Rückstellmittel, die dazu geeignet sind das Betätigungselement, bei Ausbleiben der Betätigungskraft zurück in die Anschlagsbegrenzungsstellung zu bewegen, wenn das Betätigungsteil über diese hinausbewegt wurde.

Erfindungsgemäß umfasst das Bedienelement zweite Rückstellmittel, die dazu ausgebildet sind das Bedienelement aus einer Betätigungsstellung zurück in die Ruhestellung zu bewegen, wobei die zweiten Rückstellmittel eine lineare Kennlinie aufweisen. Beispielsweise sind die zweiten Rückstellmittel aus einem Federblech ausgebildet.

In einer Ausgestaltung wirkt eine, aus erster und zweiter Elektrode als zweites Rückstellmittel.

In einer Ausgestaltung ist wenigstens ein Anschlagsbegrenzer und ein zweites Rückstellmittel in Serie geschaltet.

In einer Ausgestaltung ist wenigstens ein Anschlagsbegrenzer und ein zweites Rückstellmittel parallel geschaltet.

Die Federkonstanten der Rückstellmittel sind im kraftlosen Zustand klein gegenüber der "Federkonstante" des Betätigungsteils und des Trägers, so dass sich diese bei geringer Kraftbeaufschlagung von etwa 0-5 N im Wesentlichen nicht durchbiegen.

Ferner betrifft die Erfindung die Verwendung eines Bedienelements gemäß einer der vorher beschriebenen Ausführungsformen in einem Kraftfahrzeug.

Die Erfindung wird anhand der nachfolgenden Figuren näher erläutert. Die Figuren sind dabei beispielhaft zu verstehen und stellen lediglich schematisch beispielhafte Ausführungsvariante dar. In den einzelnen Figuren sind dabei gleiche Teile oder gleichwirkende Teile jeweils mit den gleichen Bezugszeichen versehen. Es zeigen:
Fig. 1 einen Querschnitt durch ein Bedienelement 1 gemäß einer ersten Ausführungsform in einer Anschlagsbegrenzungsstellung;
Fig. 2 einen Querschnitt durch ein Bedienelement 1 gemäß einer zweiten Ausführungsform in einer Anschlagsbegrenzungsstellung;
Fig. 3 einen Querschnitt durch ein Bedienelement 1 gemäß einer dritten Ausführungsform in einer Anschlagsbegrenzungsstellung;
Fig. 4 einen Querschnitt durch ein Bedienelement 1 gemäß einer vierten Ausführungsform in einer Anschlagsbegrenzungsstellung;
Fig. 5 einen Querschnitt durch ein Bedienelement 1 gemäß einer fünften Ausführungsform in einer Anschlagsbegrenzungsstellung;
Fig. 6 ein Kraft-Weg-Diagramm für Rückstellmittel mit linearer und progressiver Kennlinie.

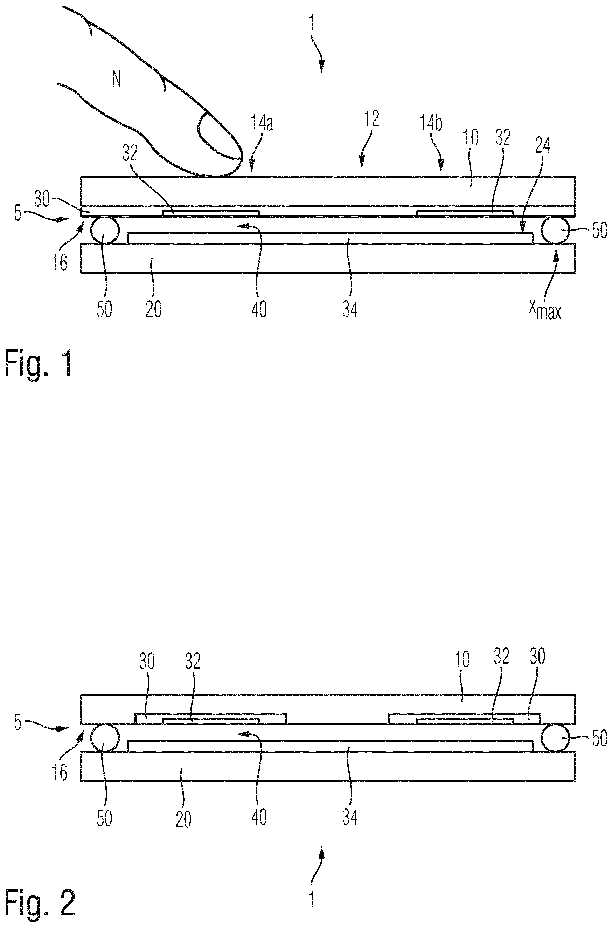

In Fig. 1 ist ein Querschnitt durch ein Bedienelement 1 gemäß einer ersten nicht erfindungsgemäßen Ausführungsform gezeigt. Das Bedienelement 1 wird vom Nutzer an einer berührungsempfindlichen Oberfläche 12 eines Betätigungsteils 10 berührt und gedrückt. Dabei beaufschlagt er das Betätigungsteil 10 mit einer Betätigungskraft senkrecht zu der berührungsempfindlichen Oberfläche 12. Diese Betätigungskraft wird durch Kraftsensoren, die zwischen dem Betätigungsteil 10 und einem Träger 20 angeordnet sind gemessen. Der Kraftsensor beruht auf dem Prinzip der relativen kapazitiven Abstandsmessung zwischen dem Betätigungsteil 10 und dem Träger 20. Dazu ist eine Leiterplatte oder Sensorfolie 30 mit ersten Elektroden 32 auf einer dem Nutzer abgewandten Seite 16 des Betätigungsteils ausgebildet. Dem gegenüber ist trägerseitig eine zweite Elektrode 34 ausgebildet, die geerdet ist. Eine erste Elektrode 32 bildet mit der zweiten Elektrode jeweils einen Messkondensator, dessen Kapazität vom lichten Abstand 40 zwischen den Elektroden abhängt.

Durch das Einwirken der Betätigungskraft ist das Betätigungsteil 10 aus einer Ruhestellung in Richtung des Trägers 20 in eine Betätigungsstellung bewegbar. Der Begriff Betätigungsstellung ist dabei weit auszulegen und meint zunächst jede Stellung außerhalb der Ruhestellung. Insbesondere aber die Stellung, die das Betätigungsteil 10 einnimmt, wenn eine einem Betätigungsbereich 14a, 14b zugeordnete Funktion ausgelöst wird. Durch die Bewegung des Betätigungsteils 10 in Richtung des Trägers 20 verringert sich der lichte Abstand 40 zwischen der ersten Elektrode 32 und der zweiten Elektrode.

Zwischen der dem Nutzer abgewandten Seite 16 des Betätigungsteils 10 und der gegenüberliegenden Seite 22 des Trägers 20 sind in einem Randbereich Anschlagsbegrenzer 50 angeordnet. Diese weisen eine progressive Kennlinie auf und werden komprimiert, wenn das Betätigungsteil 10 über die gezeigte Anschlagsbegrenzungsstellung hinaus, das heißt über die Stellung, in der das Betätigungsteil 10 in Berührkontakt mit dem Anschlagsbegrenzer 50 tritt, bewegt wird. Bei Wegfall der Betätigungskraft wirken die Anschlagsbegrenzer 50 als erste Rückstellmittel, die das Betätigungsteil 10 in die Anschlagsbegrenzungsstellung zurückstellen.

In der gezeigten Ausführungsform sind es Bereiche der Leiterplatte oder Sensorfolie 30, die in Berührkontakt mit den Anschlagsbegrenzern 50 sind.

Die in Fig. 2 gezeigte Ausführungsform des Bedienelements 1 unterscheidet sich von der in Fig. 1 gezeigten, dadurch, dass die Anschlagsbegrenzer 50 in einem Randbereich 5 des Betätigungsteils 10 zumindest in der Anschlagsbegrenzungsstellung direkt in Berührkontakt mit der dem Nutzer abgewandten Seite 16 des Betätigungsteils 10 stehen.

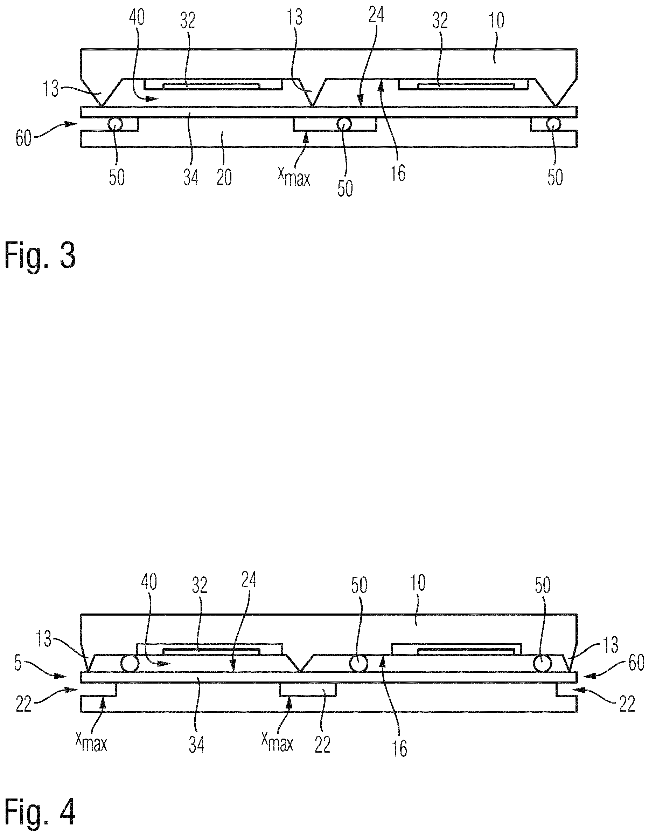

In der in Fig. 3 gezeigten, erfindungsgemäßen Ausführungsform werden die Anschlagsbegrenzer 50 als progressive erste Rückstellmittel in Reihe mit zweiten Rückstellmitteln 60 mit linearer Kennlinie gesetzt. Das zweite Rückstellmittel 60 ist ein Federblech, welches zugleich auch die zweite Elektrode 34 ausbildet, die an der dem Nutzer zugewandten Seite 24 des Trägers 20 angeordnet ist. Der Träger 20 weist an der dem Nutzer zugewandten Seite 24 Aussparungen 22 auf. Die freien Enden der als Federblech ausgebildeten zweiten Elektrode 34 überragen die Aussparungen 22. Über an der dem Nutzer abgewandten Seite 16 des Betätigungsteils 10 angeordnete Stößel 13 wird die ausgeübte Betätigungskraft auf das Federblech übertragen, welches sich dadurch verbiegt. In den Aussparungen 22 sind die Abstandsbegrenzer 50 angeordnet, welche verhindern, dass das Federblech in den Aussparungen 22 in Berührkontakt mit dem Träger 20 was einen harten Endanschlag xₘₐₓ darstellen würde.

Die in Fig. 4 gezeigte Ausführungsform unterscheidet sich von der in Fig. 3 gezeigten Ausführungsform dadurch, dass die als erste Rückstellmittel wirkende Anschlagsbegrenzer 50 und die zweiten Rückstellmittel 60 parallel geschaltet sind. Die Abstandsbegrenzer 50 sind in dem Fall zwischen der dem Nutzer abgewandten Seite 16 des Betätigungsteils 10 und der als Federblech ausgebildeten zweiten Elektrode 34 angeordnet. Dies in einem Bereich, in welchem das Federblech die trägerseitigen Aussparungen 22 nicht überragt.

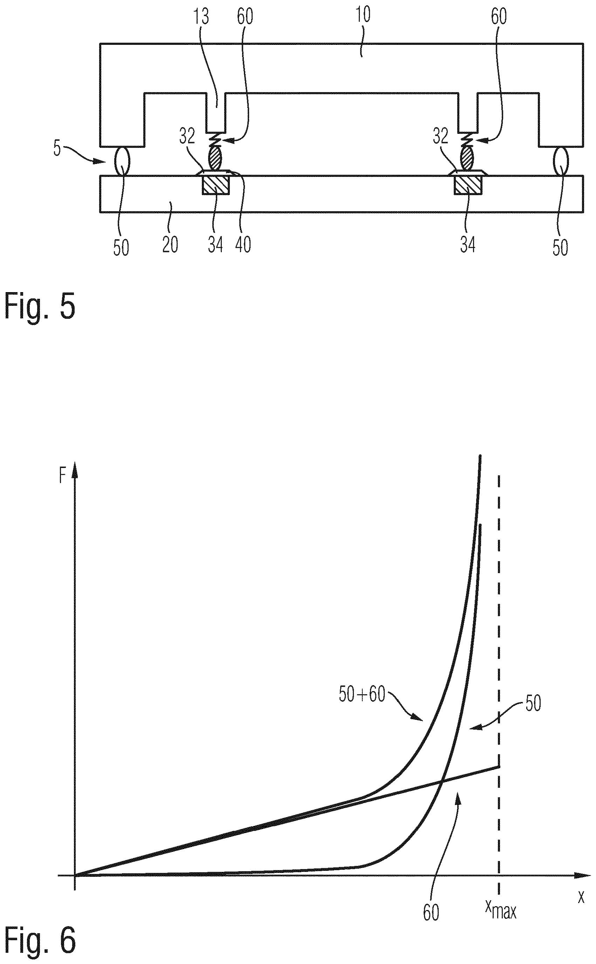

Fig. 5 zeigt eine weiter Ausführungsform der Erfindung. In dieser sind die ersten Elektroden 32 als Stanz-Biegeteile, beispielsweise aus Blech ausgeführt und auf dem Träger 20 aufgebracht. Die ersten Elektroden 32 sind den zweiten Elektroden 34 gegenüberliegend angeordnet, wobei die zweiten Elektroden 34 ebenfalls dem Träger zuzuordnen sind. Die Stanz-Biegeteile sind brückenartig ausgebildet und überragen die zugehörigen zweiten Elektroden 34 mit einem lichten Abstand 40. Der Träger 20 überträgt über Stößel 13 und zweite Rückstellmittel 60 die Betätigungskraft auf die Stanz-Biegeteile, wodurch diese verformt werden und sich der zugehörigen zweiten Elektrode annähern. In Fig. 5 sind die zweiten Rückstellmittel 60 stark vereinfacht als Federn dargestellt. Insbesondere kann es sich dabei um Z-Federn handeln. Oder eine Kombination aus Z-Federn und weiteren Mitteln mit linearer und/oder progressiver Kennlinie. In dem Randbereich 18 sind zwischen dem Bedienteil 10 und dem Träger 20 Abstandsbegrenzer 50 angeordnet. Zwischen den zweiten Rückstellmitteln 60 und der jeweiligen ersten Elektrode 32 ist jeweils noch ein Element 70 mit progressiver Kennlinie angeordnet. Wobei die Federkonstante von diesem Element 70 größer ist als die Federkonstante von den Abstandsbegrenzern 50.

In Fig. 6 zeigt schematisch ein Kraft-Weg-Diagramm F-x für Rückstellmittel mit linearer und progressiver Kennlinie, beispielsweise für Anschlagsbegrenzer 50 und zweite Rückstellmittel. Zudem ist schematisch der Kraft-Weg Verlauf für parallel geschaltete Rückstellmittel mit linearer und progressiver 60+50 Kennlinie gezeigt. Durch eine gestrichelte, zur x-Achse senkrechten Linie ist die Position eines Endanschlags xₘₐₓ angezeigt. Bei zweiten Rückstellmitteln 60 mit linearer Kennlinie, ist, wie der Name bereits sagt, das Kraft-Weg Diagramm eine Gerade. Bei den Anschlagsbegrenzern muss jedoch, je mehr man sich dem Endanschlag annähert zunehmen Kraft aufwenden, um eine Strecke x zurück zu legen. Der Endanschlag xₘₐₓ wird nie ganz erreicht werden.

## Patentansprüche

1. Bedienelement (1) aufweisend
einen Träger (20) und ein in Richtung des Trägers (20) unter Einwirkung einer Betätigungskraft beweglich gelagertes Betätigungsteil (10) mit einer einem Nutzer zugewandten berührungsempfindlichen Oberfläche (12), wobei das Betätigungsteil (10) aus einer Ruhestellung in eine Betätigungsstellung bewegbar ist und das Betätigungsteil (10) auf seiner berührungsempfindlichen Oberfläche wenigstens zwei Betätigungsbereiche (14a, 14 b) aufweist, und
mehrere zwischen dem Betätigungsteil (10) und dem Träger (20) angeordnete berührungslose Sensoren, die dazu ausgebildet sind, eine Einwirkung einer Betätigungskraft zu erkennen,
einen trägerseitigen Endanschlag (xₘₐₓ), und
mehrere zwischen der dem Nutzer abgewandten Seite des Betätigungsteils (10) und dem Träger angeordnete Anschlagsbegrenzer (50), wobei die Anschlagsbegrenzer (50) wenigstens zur teilweisen Rückstellung des Betätigungsteils (10) aus der Betätigungsstellung in die Anschlagsbegrenzungsstellung ausgebildet sind und die Anschlagsbegrenzer (50) als erstes Rückstellmittel wirken, und
wobei vor dem Erreichen des Endanschlags (xₘₐₓ) der Anschlagsbegrenzer (50) komprimiert wird, der eine progressive Kennlinie aufweist,
**dadurch gekennzeichnet, dass** zusätzlich wenigstens ein zweites Rückstellmittel (60) mit linearer Kennlinie vorgesehen ist, das zwischen der dem Nutzer abgewandten Seite (16) des Betätigungsteils (10) und dem Träger (20) angeordnet ist, und wobei wenigstens ein Anschlagsbegrenzer (50) und wenigstens ein zweites Rückstellmittel (60) mit linearer Kennlinie in Serie geschaltet sind.

2. Bedienelement (1) gemäß dem vorhergehenden Anspruch, wobei das Betätigungsteil (10) in einer Anschlagsbegrenzungsstellung in Berührkontakt mit dem Anschlagsbegrenzer (50) tritt.

3. Bedienelement (1) aufweisend
einen Träger (20) und ein in Richtung des Trägers (20) unter Einwirkung einer Betätigungskraft beweglich gelagertes Betätigungsteil (10) mit einer einem Nutzer zugewandten berührungsempfindlichen Oberfläche (12),
wobei das Betätigungsteil (10) aus einer Ruhestellung in eine Betätigungsstellung bewegbar ist und das Betätigungsteil (10) auf seiner berührungsempfindlichen Oberfläche wenigstens zwei Betätigungsbereiche (14a, 14 b) aufweist, und
mehrere zwischen dem Betätigungsteil (10) und dem Träger (20) angeordnete berührungslose Sensoren, die dazu ausgebildet sind, eine Einwirkung einer Betätigungskraft zu erkennen,
einen trägerseitigen Endanschlag (xₘₐₓ), und
mehrere zwischen der dem Nutzer abgewandten Seite des Betätigungsteils (10) und dem Träger angeordnete Anschlagsbegrenzer (50), wobei die Anschlagsbegrenzer (50) wenigstens zur teilweisen Rückstellung des Betätigungsteils (10) aus der Betätigungsstellung in die Anschlagsbegrenzungsstellung ausgebildet sind und die Anschlagsbegrenzer (50) als erstes Rückstellmittel wirken, und
wobei vor dem Erreichen des Endanschlags (xₘₐₓ) der Anschlagsbegrenzer (50) komprimiert wird, der eine progressive Kennlinie aufweist,
**dadurch gekennzeichnet, dass** es sich bei den Sensoren um kapazitive Kraftsensoren handelt, wobei sich unter Einwirkung der Betätigungskraft eine erste Elektrode (32) an eine zweite Elektrode (34) annähert, und wobei sich unter Einwirkung einer Betätigungskraft wenigstens eine aus erster und zweiter Elektrode (32, 34) verbiegt, und nach dem Wegfall der Betätigungskraft dazu geeignet ist, als zweite Rückstellmittel (60) zu wirken.

4. Bedienelement (1) gemäß Anspruch 3, wobei wenigstens ein Anschlagsbegrenzer (50) und wenigstens ein zweites Rückstellmittel (60) mit linearer Kennlinie in Serie geschaltet sind.

5. Bedienelement (1) gemäß einem der vorhergehenden Ansprüche 3 oder 4, wobei wenigstens ein Anschlagsbegrenzer (50) und wenigstens ein zweites Rückstellmittel mit linearer Kennlinie parallel geschaltet sind.

6. Bedienelement (1) gemäß einem der vorhergehenden Ansprüche 3 bis 5, wobei wenigstens eine aus erster und zweiter Elektrode (32, 34) aus Federblech ausgebildet ist.

7. Verwendung eines Bedienelements (1) gemäß einem der vorhergehenden Ansprüche in einem Kraftfahrzeug.

## Claims

1. Operating element (1) having
a support (20) and an actuating part (10) which is mounted such that it can be moved in the direction of the support (20) under the action of an actuating force and which comprises a touch sensitive surface (12) facing a user,
wherein the actuating part (10) can be moved out of a rest position into an actuating position, and the actuating part (10) has at least two actuating regions (14a, 14b) on its touch sensitive surface, and
a plurality of non-contacting sensors, which are arranged between the actuating part (10) and the support (20) and are designed to detect an action of an actuating force,
an end stop (xₘₐₓ) on the support side, and
a plurality of stop limiters (50) which are arranged between the side of the actuating part (10) that faces the user and the support, wherein the stop limiters (50) are designed to at least partly restore the actuating part (10) from the actuating position into the stop limiting position, and the stop limiters (50) act as a first restoring means, and
wherein the stop limiter (50), which has a progressive characteristic, is compressed before the end stop (xₘₐₓ) is reached,
**characterized in that**
in addition, at least one second restoring means (60) with a linear characteristic is provided, which is arranged between the side (16) of the actuating part (10) that faces the user and the support (20),
and wherein at least one stop limiter (50) and at least one second restoring means (60) with a linear characteristic are connected in series.

2. Operating element (1) according to the preceding claim, wherein the actuating part (10) comes into contact with the stop limiter (50) in a stop limiting position.

3. Operating element (1) having
a support (20) and an actuating part (10) which is mounted such that it can be moved in the direction of the support (20) under the action of an actuating force and which comprises a touch sensitive surface (12) facing a user,
wherein the actuating part (10) can be moved out of a rest position into an actuating position, and the actuating part (10) has at least two actuating regions (14a, 14b) on its touch sensitive surface, and
a plurality of non-contacting sensors, which are arranged between the actuating part (10) and the support (20) and are designed to detect an action of an actuating force,
an end stop (xₘₐₓ) on the support side, and
a plurality of stop limiters (50) which are arranged between the side of the actuating part (10) that faces the user and the support, wherein the stop limiters (50) are designed to at least partly restore the actuating part (10) from the actuating position into the stop limiting position, and the stop limiters (50) act as a first restoring means, and
wherein, before the end stop (xₘₐₓ) is reached, the stop limiter (50), which has a progressive characteristic, is compressed,
**characterized in that**
the sensors are capacitive force sensors, wherein, under the action of the actuating force, a first electrode (32) approaches a second electrode (34),
and wherein, under the action of an actuating force, at least one of the first and second electrodes (32, 34) bends and, after the actuating force has been removed, is suitable to act as a second restoring means (60).

4. Operating element (1) according to Claim 3, wherein at least one stop limiter (50) and at least one second restoring means (60) with a linear characteristic are connected in series.

5. Operating element (1) according to one of the preceding Claims 3 or 4, wherein at least one stop limiter (50) and at least one second restoring means with a linear characteristic are connected in parallel.

6. Operating element (1) according to one of the preceding Claims 3 to 5, wherein at least one of the first and second electrodes (32, 34) is formed from spring steel sheet.

7. Use of an operating element (1) according to one of the preceding claims in a motor vehicle.

## Revendications

1. Élément de commande (1) possédant
un élément porteur (20) et une pièce d'actionnement (10), montée mobile en direction de l'élément porteur (20) sous l'effet d'une force d'actionnement et pourvue d'une surface (12) tactile faisant face à un utilisateur,
la pièce d'actionnement (10) pouvant être déplacée d'une position de repos en une position d'actionnement et la pièce d'actionnement (10) possédant au moins deux zones d'actionnement (14a, 14b) sur sa surface tactile, et
plusieurs capteurs sans contact disposés entre la pièce d'actionnement (10) et l'élément porteur (20), lesquels sont configurés pour reconnaître un effet d'une force d'actionnement,
une butée finale (xₘₐₓ) côté élément porteur, et
plusieurs limiteurs de butée (50) disposés entre le coté de la pièce d'actionnement (10) à l'opposé de l'utilisateur et l'élément porteur, les limiteurs de butée (50) étant configurés pour le rappel au moins partiel de la pièce d'actionnement (10) depuis la position d'actionnement dans la position de limitation de butée et les limiteurs de butée (50) agissant comme des premiers moyens de rappel, et
avant d'atteindre la butée finale (xₘₐₓ), le limiteur de butée (50) étant comprimé, celui-ci présentant une courbe caractéristique progressive, **caractérisé en ce que**
au moins un deuxième moyen de rappel (60) à courbe caractéristique linéaire est en plus présent, lequel est disposé entre le côté (16) de la pièce d'actionnement (10) à l'opposé de l'utilisateur et l'élément porteur (20),
et au moins un limiteur de butée (50) et au moins un deuxième moyen de rappel (60) à courbe caractéristique linéaire étant branchés en série.

2. Élément de commande (1) selon la revendication précédente, la pièce d'actionnement (10) dans une position de limitation de butée entrant en contact avec le limiteur de butée (50).

3. Élément de commande (1) possédant
un élément porteur (20) et une pièce d'actionnement (10), montée mobile en direction de l'élément porteur (20) sous l'effet d'une force d'actionnement et pourvue d'une surface (12) tactile faisant face à un utilisateur,
la pièce d'actionnement (10) pouvant être déplacée d'une position de repos en une position d'actionnement et la pièce d'actionnement (10) possédant au moins deux zones d'actionnement (14a, 14b) sur sa surface tactile, et
plusieurs capteurs sans contact disposés entre la pièce d'actionnement (10) et l'élément porteur (20), lesquels sont configurés pour reconnaître un effet d'une force d'actionnement,
une butée finale (xₘₐₓ) côté élément porteur, et
plusieurs limiteurs de butée (50) disposés entre le coté de la pièce d'actionnement (10) à l'opposé de l'utilisateur et l'élément porteur, les limiteurs de butée (50) étant configurés pour le rappel au moins partiel de la pièce d'actionnement (10) depuis la position d'actionnement dans la position de limitation de butée et les limiteurs de butée (50) agissant comme des premiers moyens de rappel, et
avant d'atteindre la butée finale (xₘₐₓ), le limiteur de butée (50) étant comprimé, celui-ci présentant une courbe caractéristique progressive, **caractérisé en ce que**
les capteurs sont des capteurs de force capacitifs, une première électrode (32) s'approchant d'une deuxième électrode (34) sous l'effet de la force d'actionnement,
et sous l'effet d'une force d'actionnement, au moins l'une parmi la première et la deuxième électrode (32, 34) se plie et est appropriée pour agir en tant que deuxième moyen de rappel (60) après la suppression de la force d'actionnement.

4. Élément de commande (1) selon la revendication 3, au moins un limiteur de butée (50) et au moins un deuxième moyen de rappel (60) à courbe caractéristique linéaire étant branchés en série.

5. Élément de commande (1) selon l'une des revendications précédentes 3 et 4, au moins un limiteur de butée (50) et au moins un deuxième moyen de rappel à courbe caractéristique linéaire étant branchés en parallèle.

6. Élément de commande (1) selon l'une des revendications précédentes 3 à 5, au moins l'une parmi la première et la deuxième électrode (32, 34) étant réalisée en tôle à ressort.

7. Utilisation d'un élément de commande (1) selon l'une des revendications précédentes dans un véhicule automobile.
